# EUROPEAN PATENT SPECIFICATION

(11) **EP 3 346 221 B1**
(45) Date of publication and mention of the grant of the patent: **04.03.2020**
(21) Application number: 17150530.8
(22) Date of filing: 06.01.2017
(51) Int. Cl.: F28F 27/02, F28D 15/06, H05K 7/20, F28D 15/02, F25B 41/06, F25B 49/02

(54) **COOLING REGULATION SYSTEM AND METHOD FOR COOLING REGULATION**
KÜHLUNGSREGULIERUNGSSYSTEM UND VERFAHREN ZUR KÜHLUNGSREGULIERUNG
SYSTÈME DE RÉGULATION DE REFROIDISSEMENT ET PROCÉDÉ DE RÉGULATION DE REFROIDISSEMENT

(43) Date of publication of application: 11.07.2018
(73) Proprietor: ABB Schweiz AG, 5400 Baden (CH)
(72) Inventor: Sologubenko, Oleksandr, 8906 Bonstetten (CH); Kaufmann, Lilian, 5413 Birmenstorf (CH)
(74) Representative: Zimmermann & Partner Patentanwälte mbB

(56) References cited:
- EP-A1- 0 002 305
- EP-A1- 0 670 460
- WO-A1-2016/129044
- JP-A- H0 445 393
- US-A- 3 414 050
- US-A- 4 979 372
- US-A1- 2007 017 239

## Description

### TECHNICAL FIELD

Embodiments of the present disclosure relate to cooling regulation systems and methods for cooling regulation. In particular, embodiments of the present disclosure relate to automatic cooling regulation systems and methods for automatic cooling regulation. More specifically, embodiments of the present disclosure relate to systems and methods suitable for automatic refrigerant flow regulation in an evaporator of a cooling regulation system.

### BACKGROUND

In the current generation of high voltage direct current (HVDC) converters, insulated-gate bipolar transistors (IGBTs) are typically cooled by a forced water flow. However, due to the technological trend towards more compact designs the conventional thermal management may become insufficient. The main reason is the increased total heating power density, since the heat-generating parts (IGBTs) are packed more closely. In order to overcome the emerging thermal management issues, cooling systems for converters, based on 2-phase forced evaporative (boiling) cooling of a dielectric working fluid, have been suggested.

However, there are some issues with the conventional cooling systems that are related to the fact that typically a large number of evaporators are fluidly connected in parallel. The fluid distribution is determined by several fluid resistance contributions, caused by friction, inertial effects, and gravity. The cumulative effect of these resistances and the associated pressure drop is unavoidably different for different branches of fluid distribution. In particular, in the case of a vertical arrangement of a converter valve, for IGBTs at different elevations, the evaporator inlet pressure varies due to the elevation difference. Further, the fluid velocity is different in different parts of the fluid distribution manifold and the pressure drop of fluid boiling in the evaporators depends on the IGBT heating power which may vary from cell to cell.

These and other reasons of inequality of pressure drop in parallel fluid flow branches lead to different flow rates in different branches. If heat losses generated by a single IGBT in a converter valve is higher than a critical value, the fluid in a flow branch boils completely. This leads to drying out of a part of its evaporator and, as a consequence, a rapid increase of temperature of certain IGBTs to a dangerous level may occur, possibly even leading to thermal runaway. The situation may be exacerbated if the heat generated by an IGBT suddenly changes but the flow rate in the associated flow branch is constant. One solution would be to use an electronic valve upstream of each evaporator, controlled by feedback from a thermometer sensing the temperature of the IGBT. However, an implementation of this solution, which requires auxiliary power supply for the valve and the temperature sensor, may be problematic in applications like HVDC converter, where different evaporators are at high voltage, with each evaporator at a different electrical potential.

With respect to the prior art, exemplary reference is made to document EP 0670 460 A1. Document EP 0670 460 A1 relates to relates to refrigerating apparatus, more particularly is suitable for use in refrigerating apparatus having a plurality of evaporators in a single refrigeration cycle. In particular, Document EP 0670 460 A1 describes an adsorbent enclosed in a gas control tube communicating with a thermosensitive tube of an expansion valve via a capillary tube adsorbs a refrigerant gas enclosed in the hermetically sealed space from a thermosensitive tube to a gas control tube. When this is heated by an electric heater, there is discharge of the refrigerant gas that was adsorbed up to then so that passage of current to the electric heater stops and there is adsorption of the refrigerant gas at normal temperature to a saturation state. As a result, if the electric current to the electric heater is stopped so that the adsorbent adsorbs the refrigerant gas, the pressure in the thermosensitive chamber (hermetically sealed space) drops and an expansion valve closes completely.

In light of the foregoing, there is a need to provide systems and methods for cooling regulation that overcome at least some of the problems in the art.

### SUMMARY

In light of the above, a cooling regulation system and a method for automatic cooling regulation according to the independent claims are provided. Further aspects, benefits, and features of the present disclosure are apparent from the claims, the description, and the accompanying drawings.

According to an aspect of the present disclosure, a cooling regulation system is provided. The cooling regulation system includes: a valve having an control device provided in the interior of the valve, wherein the control device is configured for controlling an opening of an orifice provided between a valve inlet and a valve outlet such that a flow of a coolant from the valve inlet to the valve outlet can be regulated; an evaporator with a contact surface that is adapted to be thermally connected to a heat source such that a thermal load from the heat source is dissipated by the evaporator in an operating state of the cooling regulation system, the evaporator having an evaporator inlet connected to the valve outlet; and a regulation device configured for providing a temperature dependent gas pressure to the valve for regulating a position of the control device in order to regulate the flow of the coolant; wherein the regulation device is in thermal contact with the evaporator at a position at which a vapor quality χ of the coolant is χ ≤ χ_{cr}, wherein χ_{cr} is the critical vapor quality, and wherein the regulation device is positioned in a heat flow path between the heat source and at least one channel of an array of channels of the evaporator through which the coolant is provided.

According to another aspect of the present disclosure, a cooling regulation system is provided. The cooling regulation system includes: a valve having an control device provided in the interior of the valve, wherein the control device is configured for controlling an opening of an orifice provided between a valve inlet and a valve outlet such that a flow of a coolant from the valve inlet to the valve outlet can be regulated; an evaporator with a contact surface that is adapted to be thermally connected to a heat source such that a thermal load from the heat source is dissipated by the evaporator in an operating state of the cooling regulation system, the evaporator having an evaporator inlet connected to the valve outlet; a heater provided at an outlet piping of the evaporator, wherein the heater is in thermal contact with the outlet piping via a thermally conducting element; a regulation device configured for providing a temperature dependent gas pressure to the valve for regulating a position of the control device in order to regulate the flow of the coolant; wherein the regulation device is in thermal contact with thermally conducting element, wherein the heater is configured to provide a fixed heating power, wherein the fixed heating power is selected such that the heat flux through the thermally conducting element is similar to the maximum potential heat flux through the evaporator.

According to a further aspect of the present disclosure, a power module, including at least one cooling regulation system according any of the embodiments described herein, wherein at least one of a heat-generating electronic component and a heat-generating electric component is thermally connected to the contact surface of the evaporator.

According to yet another aspect of the present disclosure, a method for automatic cooling regulation is provided. The method includes: providing a coolant in a subcooled state into a valve via a valve inlet; guiding the coolant through an orifice having a controllable opening into an evaporator, wherein the orifice is provided between the valve inlet and a valve outlet connected to the evaporator; providing a first heat transfer from a heat source to the coolant in the evaporator such that a thermal load from the heat source is dissipated by the evaporator in an operating state of the cooling regulation system; providing a second heat transfer to a regulation device configured for providing a temperature dependent gas pressure to the valve in order to regulate a coolant flow, wherein the regulation device is either in thermal contact with the evaporator at a position at which a vapor quality χ of the coolant is χ ≤ χcr, wherein χ_{cr} is the critical vapor quality, the regulation device being positioned in a heat flow path between the heat source and at least one channel of an array of channels of the evaporator through which the coolant is provided, or wherein the regulation device is in thermal contact with a thermally conducting element which is in thermal contact with a heater provided at an outlet piping of the evaporator, wherein the heater is configured to provide a fixed heating power which is selected such that the heat flux through the thermally conducting element is similar to a maximum potential heat flux through the evaporator; and regulating the coolant flow by a control device provided in the interior of the valve, wherein the control device is configured for a controlling the opening of the orifice provided between the valve inlet and the valve outlet.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- Fig. 1: shows a schematic view of a cooling regulation system having a valve, an evaporator and a regulation device according to embodiments described herein;
- Fig. 2: shows a schematic view of a part of the cooling regulation system including an evaporator according to embodiments described herein;
- Fig. 3: shows a schematic view of a part of the cooling regulation system according to embodiments described herein in which the regulation device is in thermal contact with a thermally conducting element which is in thermal contact with a heater provided at an outlet piping of the evaporator;
- Fig. 4: shows a schematic graphs of the heat transfer coefficient (*h*), the temperature of the evaporator (*Tₑ*), and the temperature of the fluid (*T_{fl}*) along the flow of refrigerant in a channel with a constant heat flux for better understanding of the cooling regulation system described herein;
- Fig. 5: shows an exemplary graph of automatic flow regulation by stepwise reduction of heating power for better understanding of the cooling regulation system described herein;
- Fig. 6A: shows an exemplary graph of the mass flow rate as a function of heating power for several set values of the evaporator pressure for better understanding of the cooling regulation system described herein;
- Fig. 6B: shows an exemplary graph of an outlet vapor quality as a function of heating power for several set values of the evaporator pressure for better understanding of the cooling regulation system described herein; and
- Fig. 7: shows a flow chart illustrating a method for automatic cooling regulation according to embodiments described herein.

### DETAILED DESCRIPTION OF EMBODIMENTS

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment can apply to a corresponding part or aspect in another embodiment as well.

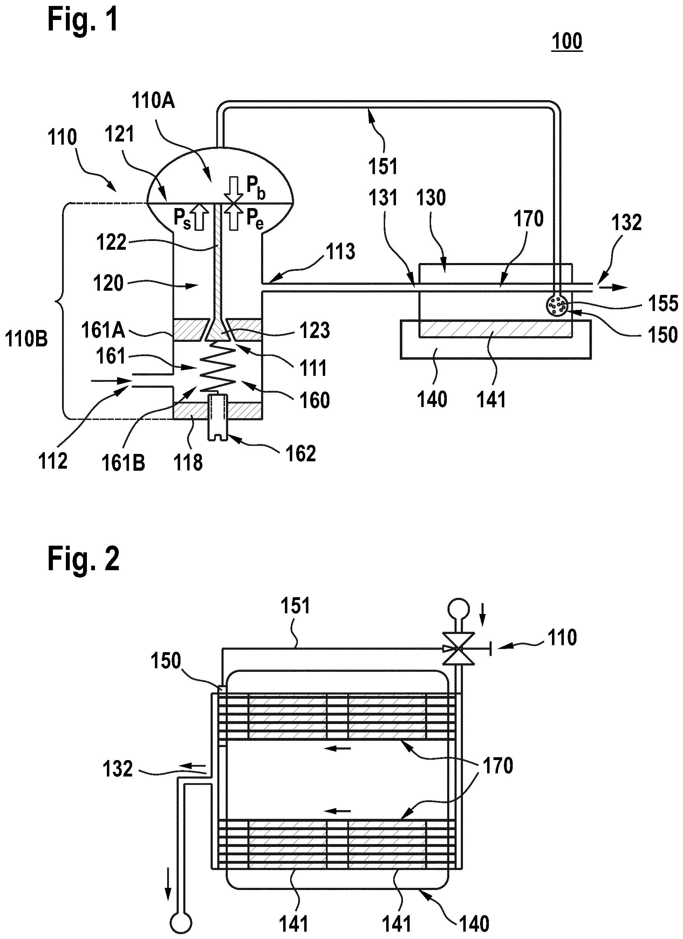

Fig. 1 shows a schematic view of a cooling regulation system 100 according to embodiments described herein. The cooling regulation system 100 includes a valve 110 having a control device 120 provided in the interior of the valve 110. The control device 120 is configured for controlling an opening of an orifice 111 provided between a valve inlet 112 and a valve outlet 113 such that a flow of a coolant from the valve inlet 112 to the valve outlet 113 can be regulated. Further, the cooling regulation system 100 includes an evaporator 130 with a contact surface that is adapted to be thermally connected to a heat source 140, 141 such that a thermal load from the heat source 140, 141 is dissipated by the evaporator in an operating state of the cooling regulation system 100. As exemplarily shown in Fig. 1, typically the evaporator 130 has an evaporator inlet 131 connected to the valve outlet 113. Further, the cooling regulation system 100 includes a regulation device 150 configured for providing a temperature dependent gas pressure to the valve 110 for regulating a position of the control device 120 in order to regulate the flow of the coolant. In the exemplary embodiment shown in Fig. 1, the regulation device 150 is in thermal contact with the evaporator 130 at a position at which a vapor quality χ of the coolant is χ ≤ χ_{cr}, wherein χ_{cr} is the critical vapor quality.

In the present disclosure, it is to be understood that the critical vapor quality χ_{cr} corresponds to the critical value at the transition from the annular flow regime, where cooling is efficient, to the wall dry-out regime, where cooling efficiency drops but vapor quality is still smaller than 1. In other words, the critical vapor quality χ_{cr} corresponds to the critical value at the transition from a flow regime where cooling is efficient to a regime where cooling efficiency decreases but vapor quality is still smaller than 1, such as the transition from the annular flow regime to the wall dry-out regime. Accordingly, it is to be understood that at the critical vapor quality χ_{cr} there is a transition such that: (a) there is a change of flow regime, (b) cooling efficiency decreases strongly, and (c) the fluid remains in the saturated state (χ<1).

Accordingly, beneficially the embodiments as described herein provide for a self-regulating cooling regulation system which are configured for regulating the cooling efficiency of the evaporator. In particular, the embodiments as described herein have the advantage that a self-regulation of the cooling efficiency of the evaporator can be provided without any additional energy supply or electronic control loop such that a compact and failure resistant cooling regulation system is provided.

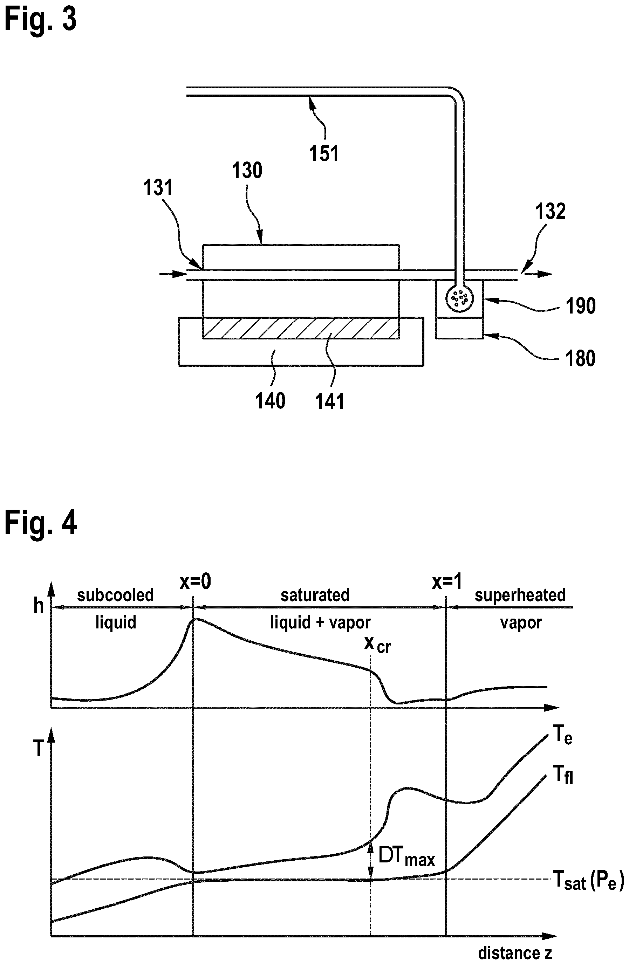

According to embodiments which can be combined with any other embodiments described herein, the regulation device 150 is positioned in a heat flow path between the heat source 140, e.g. one or more IGBT submodules 141, and at least one channel of an array of channels 170 of the evaporator 130 through which the coolant is provided, as schematically shown in Fig. 2. As exemplarily indicated in Fig. 2, the flow of coolant in the evaporator 130 typically takes place in an array of channels 170 arranged in parallel. For instance, thermal losses in IGBTs can create a heat flux between IGBT submodules 141 and the coolant flowing through the channels of the array of channels 170. In this regard, it is to be noted that the heat transfer coefficient (h) between the evaporator and the coolant is not constant along the flow direction (z) of the coolant in the evaporator, but depends on the vapor quality χ of the fluid, as exemplarily shown in Fig. 4. Above a certain value of vapor quality χ ≥ χ_{cr}, the heat transfer deteriorates rapidly. For example, in the case of an approximately homogeneous heat flux, the deterioration of heat transfer would result in an undesirable temperature rise of the heat source to be cooled, e.g. a part of an IGBT. It is to be understood that although IGBTs are mentioned as heat source, any other heat sources, which require two-phase cooling, can be used instead.

Accordingly, in contrast to conventional cooling regulations systems, embodiments of the cooling regulation system as described herein in which the regulation device is in thermal contact with the evaporator at a position at which a vapor quality χ of the coolant is χ ≤ χ_{cr} (χ_{cr} being the critical vapor quality), beneficially provide for a regulation of the cooling efficiency of the evaporator. For instance, the coolant may be water, a dielectric refrigerant such as a hydrofluorocarbon, e.g. refrigerant R134a, or any other suitable coolant.

With exemplary reference to Fig. 1, according to embodiments which can be combined with any other embodiments described herein, the regulation device 150 can include a bulb containing a solid adsorbent 155. For instance, the solid absorbent can be activated carbon and/or silica gel and/or zeolite. Accordingly, in contrast to conventional cooling regulation systems, for instance thermostatic expansion valves (TEV), the bulb of the regulation device 150 is an adsorption charge bulb instead of a refrigerant-charged bulb. Accordingly, it is to be understood that for the regulation device of the cooling regulation system as described herein, the amount of adsorbed/desorbed charge varies with temperature. Therefore, advantageously the regulation device is configured for providing an operating bulb pressure *P_{b}* without the danger of condensation in the valve head.

Typically, the bulb is set in thermal contact with the evaporator at such a spot near the array of channels, where the vapor quality of the coolant is expected to be maximum. For instance, this spot or position can be somewhere in the vicinity of the evaporator outlet. However, it is to be understood that the exact location of the bulb may depend on the specific 3D arrangement of the coolant channels of the array of channels.

Accordingly, it is to be understood that the regulation device including the bulb containing the solid adsorbent is not controlling the superheat, but rather the cooling efficiency of the evaporator. Therefore, in contrast to conventional systems in which a bulb is set in thermal contact with the vapor which leaves the evaporator, in some embodiments of the cooling regulation system as described herein the bulb is set in thermal contact with the evaporator itself. As described herein, the spot or position at the evaporator for placing the bulb is strategically selected between the coolant channels, e.g. the array of channels of the evaporator, and the heat source, e.g. IGBT submodules being hotter than the fluid channels.

As exemplarily shown in Fig. 1, according to embodiments which can be combined with any other embodiments described herein, the valve can include a first valve portion 110A connected to the regulation device 150 and a second valve portion 110B connected to the evaporator 130 via the valve outlet 113. For example, the first valve portion 110A and the regulation device 150 may contain a gas having a temperature dependent pressure.

According to embodiments which can be combined with any other embodiments described herein, the control device 120 can include a membrane 121 separating the first valve portion 110A and the second valve portion 110B. More specifically, the control device 120 may include a rod-like element 122 rigidly connected to the membrane 121. For instance, the rod-like element 122 can have an adjustment element 123 configured for adjusting the opening of the orifice 111, as exemplarily shown in Fig. 1.

According to embodiments which can be combined with any other embodiments described herein, the cooling regulation system may further include an adjustment device 160 configured for adjusting the response characteristic of the control device 120. For instance, the adjustment device 160 may include a spring element 161 having a first end 161A and a second end 161B. Typically, the first end 161A is attached to the rod-like element 122 and the second end 161B is attached to a regulating screw 162 provided in a wall 118 of the valve 110, as exemplarily shown in Fig. 1.

With exemplary reference to Fig. 1, the operation principle of the cooling regulation system 100 according to embodiments described herein is described in more detail. The coolant enters the valve 110 at the valve inlet 112 in a subcooled and purely liquid state and leaves the valve 110 at the valve outlet 113 in a subcooled state. The pressure of the coolant at the valve outlet 113 may be lower than the pressure at the valve inlet 112. Accordingly, by providing the coolant to the valve in a subcooled liquid state has the advantage that a generation of vapor can be avoided. The avoidance of coolant vapor generation is in particular beneficial since vaporized coolant provided to the evaporator would increase the coolant fluid velocity at the evaporator header which has a negative effect on the coolant fluid distribution in the evaporator, particularly with a multichannel structure. Therefore, in the embodiments described herein, the coolant is provided in a subcooled liquid state at the valve inlet 112 as well as at the valve outlet 113.

Then the coolant enters the evaporator inlet 131 of the evaporator 130. In the evaporator the coolant typically flows in array of channels 170 and accepts heat from the heat source 140, for example including one or more IGBT submodules 141. As exemplarily shown in Fig. 1, the coolant, typically leaves the evaporator 130 via an evaporator outlet 132 in a saturated state (in a steady condition) with vapor quality χ*ₒᵤₜ* ≤*x_{cr}*, wherein χ_{cr} is the critical vapor quality which is typically χ_{cr} <1. The flow of the coolant is regulated by a variable opening of the orifice 111 via a movement of a rod-like element 122, rigidly connected to a membrane 121. The membrane 121 typically separates two volumes, in particular a first valve portion 110A and a second valve portion 110B. The first valve portion 110A is connected to the regulation device 150, e.g. by a tube 151. The regulation device can include a bulb containing a solid adsorbent, such as activated carbon, silica gel, zeolite, etc.

The first valve portion 110A and the regulation device 150 are typically filled with a specially selected gas ("charge") at a certain pressure (*P_{b}*) which varies with the temperature of the bulb. Typically, the pressure (*Pₑ*) in the a second valve portion 110B is equal to the pressure of valve outlet 113, which can be close to the evaporator inlet pressure, provided that the pressure drop between the valve and the evaporator is small.

The opening of the orifice 111 is related to a flexing of the membrane 121, which is governed by three forces, associated with remote bulb pressure *P_{b}*, the evaporator pressure *Pₑ*, and the equivalent pressure *Pₛ* of the spring element 161 which can be adjusted manually by the regulating screw 162. Accordingly, for the valve to be stable, the forces need to be balanced such that *P_{b}*=*Pₛ*+*Pₑ.* In particular, the pressure balance can be achieved as follows. The expected evaporator pressure *Pₑ* is an external parameter determined by the operation point of the complete cooling system. The charge gas in the volume of the first valve portion 110A and the adsorber material, i.e. the solid adsorbent, in the bulb should be selected such that, in the range of operation pressures and at maximum potential heat flux, *Tₑ* - *T_{fl}* ≈ *ΔTₘₐₓ* holds, where *Tₑ* corresponds to the evaporator temperature, *T_{fl}* corresponds to the temperature of the coolant fluid, and *ΔTₘₐₓ* corresponds to the value at the critical vapor quality χ_{cr}, as exemplarily shown in Figure 4.

Accordingly it is to be understood, that with these measures the cooling regulation system as described herein is capable of adjusting the opening of the orifice 111 automatically, i.e. by self-regulation, in case of a variation of the heat flux from the heat source to the evaporator. In particular, it is to be understood that the difference *ΔT* between the evaporator temperature and the saturation temperature of the coolant *Tₛₐₜ*(*Pₑ*) at any point of the evaporator should be smaller than *ΔTₘₐₓ,* since the vapor quality χ would be lower than that at the point where the bulb is positioned, resulting in higher heat transfer coefficients *h*, as exemplarily shown in Fig. 4.

As exemplarily shown in Fig. 1, the bulb of the regulation device can be in thermal contact with the evaporator 130. As the evaporator becomes warmer or colder, the bulb pressure *P_{b}* increases or decreases, causing the membrane 121 to flex. This flexing of the membrane causes a movement of the rod-like element 122 such that the flow of the coolant is regulated. In particular, as can be understood from Fig. 1, when the bulb pressure *P_{b}* increases, the opening of the orifice 111 increases such that an increased coolant flow is provided. Accordingly, when the bulb pressure *P_{b}* decreases the opening of the orifice 111 decreases such that a decreased coolant flow is provided.

Accordingly, a cooling regulation system suitable for purely mechanical flow regulation is provided. In particular, the embodiments of the cooling regulation system are configured for automatically adjusting a flow resistance of the coolant. For instance, the cooling regulation system as described herein is configured for responding to changing heat, e.g. generated by IGBTs. In other words, embodiments of the cooling regulation system as described herein are configured to be self-regulating, such that no additional electronic control loop or energy supply is necessary. Thus, the cooling regulation system as described herein provides for a more compact and failure resistant design in comparison to conventional cooling regulation systems.

According to some embodiments (not explicitly shown), which can be combined with any other embodiments described herein, the evaporator may include multiple evaporators provided in a stack. In particular, the multiple evaporators may be connected to a valve and a regulation device as described herein. For instance, the multiple evaporators can be provided in a vertical stack or in a horizontal stack or any other three-dimensional arrangement. In the case the evaporator pressures *Pₑ* are not the same for all evaporators of the multiple evaporators in a stack arrangement, the differences of the evaporator pressures *Pₑ* can beneficially be compensated via an individual setting of the regulating screw 162 for each regulation valve as described herein. Accordingly, an even distribution of temperatures across multiple heat sources to be cooled, e.g. multiple IGBTs, is possible.

Further it is to be understood that various designs of evaporators, with various arrangements and geometries of fluid flow channels as well as different header geometries can be used in the cooling regulation system as described herein. For instance, the evaporator can be a flat extruded multiport evaporator.

The applicability of the cooling regulation system according to embodiments described herein was demonstrated experimentally with a prototype evaporator consisting of four parallel flat aluminum extruded multiport tubes, having in total 52 fluid flow channels with a cross-section of 1.42 × 1.5 mm². Instead of a real IGBT, a 4-submodule StakPak IGBT was substituted by four copper blocks of dimensions 82 × 48 × 12 mm³ with electric heating cartridges generating in total Q=3 kW heat. The copper blocks were placed under an array of channels 170, as schematically shown in Figure 2, and sandwiched between two steel plates, which provided the necessary pressure for good thermal contact between the blocks and multiport tubes. Refrigerant R134a was selected as the coolant fluid.

An alternative solution to the embodiment shown in Fig. 1 for providing an improved cooling system is shown in Fig. 3. In particular, Fig. 3 shows a schematic view of a part of the cooling regulation system in which the regulation device 150 is in thermal contact with a thermally conducting element 190 which is in thermal contact with a heater 180 provided at an outlet piping of the evaporator 130.

More specifically according to an alternative embodiment of the cooling regulation system, which may be combined with other embodiments described herein, the cooling regulation system 100 includes a valve 110 having an control device 120 provided in the interior of the valve 110. The control device 120 is configured for controlling an opening of an orifice 111 provided between a valve inlet 112 and a valve outlet 113 such that a flow of a coolant from the valve inlet 112 to the valve outlet 113 can be regulated. Further, the cooling regulation system 100 includes an evaporator 130 with a contact surface that is adapted to be thermally connected to a heat source 140, 141 such that a thermal load from the heat source 140, 141 is dissipated by the evaporator in an operating state of the cooling regulation system 100. The evaporator 130 typically has an evaporator inlet 131 which can be connected to the valve outlet 113. As exemplarily shown in Fig. 3, the cooling regulation system 100 further includes a heater 180 provided at an outlet piping of the evaporator 130. Typically, the heater 180 is in thermal contact with the outlet piping via a thermally conducting element 190. Further, a regulation device 150 is provided which is configured for providing a temperature dependent gas pressure to the valve 110 for regulating a position of the control device 120 in order to regulate the flow of the coolant. The regulation device 150 is in thermal contact with the thermally conducting element 190. The heater 180 is configured to provide a fixed heating power which is selected such that the heat flux through the thermally conducting element 190 is similar to the maximum potential heat flux through the evaporator 130.

Accordingly, it is to be understood that similarly to the embodiment as shown in Fig. 1, the embodiment as exemplary shown in Fig. 3 provides an alternative configuration for a cooling regulation system which has the same advantages as the embodiment described with reference to Fig. 1. In particular, by providing a cooling regulation system having a regulation device 150 in thermal contact with a heater 180 via a thermally conducting element 190 also a self-regulating system capable of regulating the cooling efficiency of the evaporator can be provided such that no additional electronic control loop is needed and a compact and failure resistant cooling regulation system is provided.

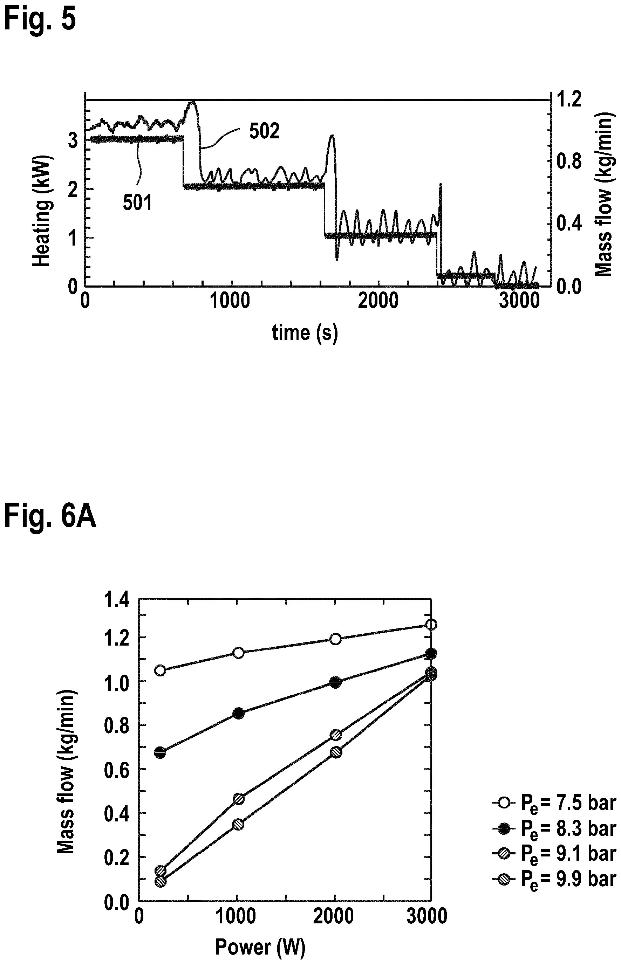

As a substitute for the custom-made flow regulation valve, a commercial TEV with suitable characteristics may be used. For example, a thermostatic expansion valve TMVX-00101, manufactured by Honeywell, with an adsorber charge of the bulb can be used. The bulb can be thermally contacted with a 2 mm thick aluminum plate, installed between the array of channels and the heater source to be cooled. For instance the valve can be configured to use external equalization at the outlet header pressure. In particular, the characteristics of the thermostatic expansion valve TMVX-00101 is dimensioned for R22 and T<15°C; therefore, this particular valve is fully functional in a setup with *T_{bulb}*>35°C (or *Pₑ*>8.8 bar). At appropriate temperatures and pressures, a gradual closing of the valve with decreasing heat Q and eventually the complete closing of the valve for *Q* →0 can be expected. This behavior is exemplarily be demonstrated by the graph shown in Fig. 5, where a stepwise reduction of heating power, represented by graph 501, leads to a reduction of the refrigerant flow rate, represented by graph 502.

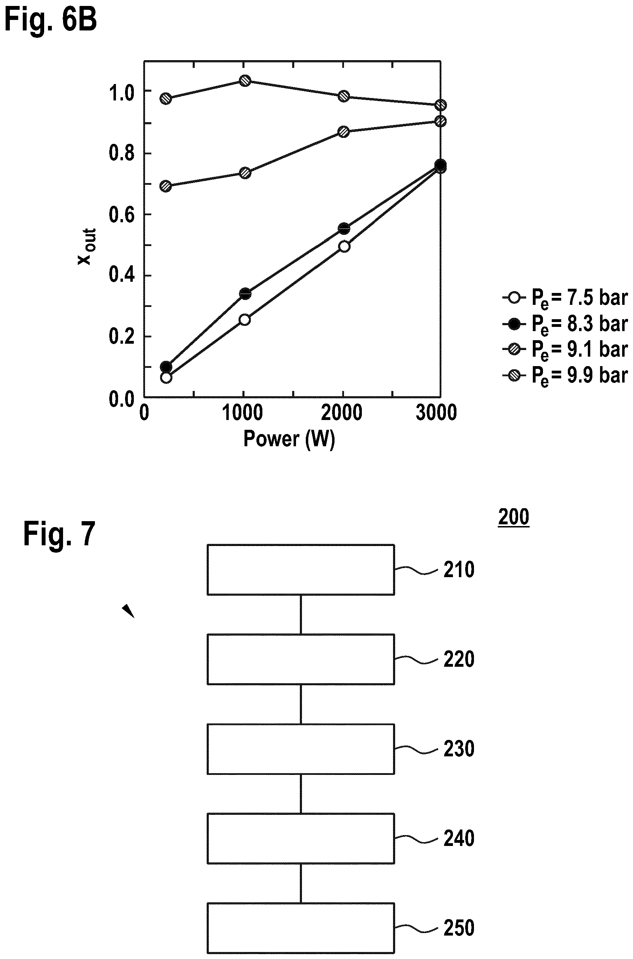

For showing the applicability of the cooling regulation system according to embodiments described herein, an exemplary graph of the mass flow rate as a function of heating power for several set values of the evaporator pressure is shown in Fig. 6A and an exemplary graph of an outlet vapor quality as a function of heating power for several set values of the evaporator pressure is shown in Fig. 6B. As can be seen from Figs. 6A and 6B, with decreasing Q, the flow rate approaches zero for *Pₑ* = 9.9 bar and *Pₑ* = 9.1 bar. The valve remains open for lower evaporator pressures (*Pₑ* = 8.3 bar and *Pₑ* = 7.5 bar), but these pressures are outside of the expected valve's full functionality range.

With exemplary reference to the flow chart shown in Fig. 7, a method for automatic cooling regulation according to embodiments described herein is described. In particular, the method 200 for automatic cooling regulation includes providing 210 a coolant in a subcooled state into a valve 110 via a valve inlet 112. Further the method includes guiding 220 the coolant through an orifice 111 having a controllable opening into an evaporator 130, wherein the orifice 111 is provided between the valve inlet 112 and a valve outlet 113 connected to the evaporator 130. Additionally, the method includes providing 230 a first heat transfer from a heat source 140, 141 to the coolant in the evaporator 130 such that a thermal load from the heat source 140, 141 is dissipated by the evaporator in an operating state of the cooling regulation system 100. Further; the method includes providing 240 a second heat transfer to a regulation device 150 configured for providing a temperature dependent gas pressure to the valve 110 in order to regulate a coolant flow.

The regulation device 150 is either in thermal contact with the evaporator 130 at a position at which a vapor quality χ of the coolant is *χ* ≤ χcr (as exemplarily described with reference to Fig. 1), or alternatively the regulation device 150 is in thermal contact with a thermally conducting element 190 which is in thermal contact with a heater 180 provided at an outlet piping of the evaporator 130 (as exemplarily described with reference to Fig. 3), wherein the heater 180 is configured to provide a fixed heating power which is selected such that the heat flux through the thermally conducting element 190 is similar to a maximum potential heat flux through the evaporator 130. Further, the method includes regulating 250 the coolant flow by a control device 120 provided in the interior of the valve 110, wherein the control device 120 is configured for a controlling the opening of the orifice 111 provided between the valve inlet 112 and the valve outlet 113. In particular, regulating 250 the coolant flow results in regulating the cooling efficiency of the evaporator 130.

Accordingly, a self-regulating cooling method is provided with which the cooling efficiency of an evaporator can be regulated, e.g. maintained in an optimum range.

According to embodiments which can be combined with any other embodiments described herein, the method may further include discharging the coolant from the evaporator in a saturated state.

According to embodiments which can be combined with any other embodiments described herein, regulating 250 the coolant flow by the control device 120 may include flexing a membrane 121 of the control device 120 such that a rod-like element 122 rigidly connected to the membrane 121 is movable in order to control the opening of the orifice 111 by an adjustment element 123 of the rod-like element 122, as exemplarily described with reference to Fig. 1. Further, the method may include adjusting the response characteristic of the control device 120 by an adjustment device 160, as exemplarily described with reference to Fig. 1.

Thus in view of the embodiments described herein, it is to be understood that an improved system and a method for cooling regulation are provided. In particular, embodiments of the cooling regulation system as described herein are fully passive, i.e. no electric current supply for a flow regulation unit is needed. This allows for installation in areas where using an auxiliary electric supply and electric cables is complicated, e.g., in high-voltage areas. Further, in the embodiments described herein, the coolant flow rate is self-regulating for the available variable heating load, without dedicated control electronics. Accordingly, the cooling efficiency is automatically adjusted to the necessary level to prevent fluid dry-out and, therefore, dangerous overheating of transistors. Further, an even distribution of coolant flow across multiple evaporators, e.g. in a stack configuration as described herein, can be easily achieved by individual setting of the corresponding adjustment screw, also referred to as regulating screw herein. A further advantage of the system and a method according to embodiments described herein is that the optimum flow rate will be automatically corrected in case the flow resistance and heat transfer deteriorate with time, for instance due to fouling or other reasons. Further, the automatic reduction of coolant flow to the minimum necessary level beneficially leads to reduced wear of the tubing and a reduction of pump load.

Accordingly, it is to be understood that the embodiments described herein are in particular suitable for two-phase cooling systems of an AC-DC converter comprising multiple IGBTs. For instance, one of the potential applications, but not exclusively, are the next-generation high voltage direct current (HVDC) converter under development at ABB, particularly well-suited for offshore converters for wind and similar applications.

## Claims

1. A cooling regulation system (100), comprising:
- a valve (110) having an control device (120) provided in the interior of the valve (110), wherein the control device (120) is configured for controlling an opening of an orifice (111) provided between a valve inlet (112) and a valve outlet (113) such that a flow of a coolant from the valve inlet (112) to the valve outlet (113) can be regulated;
- an evaporator (130) with a contact surface that is adapted to be thermally connected to a heat source (140, 141) such that a thermal load from the heat source (140, 141) is dissipated by the evaporator in an operating state of the cooling regulation system (100), the evaporator (130) having an evaporator inlet (131) connected to the valve outlet (113); and
- a regulation device (150) configured for providing a temperature dependent gas pressure to the valve (110) for regulating a position of the control device (120) in order to regulate the flow of the coolant;
wherein the regulation device (150) is in thermal contact with the evaporator (130) at a position at which a vapor quality χ of the coolant is χ ≤ χ_{cr}, wherein χ_{cr} is the critical vapor quality,
the regulation device (150) is positioned in a heat flow path between the heat source (140, 141) and at least one channel of an array of channels (170) of the evaporator (130) through which the coolant is provided.

2. The cooling regulation system (100) according to claim 1, wherein the regulation device (150) comprises a bulb containing a solid adsorbent (155), particularly activated carbon and/or silica gel and/or zeolite.

3. The cooling regulation system (100) according to any of claims 1 to 2, wherein the valve (110) comprises a first valve portion (110A) connected to the regulation device (150) and a second valve portion (110B) connected to the evaporator (130) via the valve outlet (113).

4. The cooling regulation system (100) according to claim 3, wherein the first valve portion (110A) and the regulation device (150) contain a gas having a temperature dependent pressure.

5. The cooling regulation system (100) according to claim 3 or 4, wherein the control device (120) comprises a membrane (121) separating the first valve portion (110A) and the second valve portion (110B), and wherein the control device (120) comprises a rod-like element (122) rigidly connected to the membrane (121).

6. The cooling regulation system (100) according to 5, wherein the rod-like element (122) has an adjustment element (123) configured for adjusting the opening of the orifice (111).

7. The cooling regulation system (100) according to any of claims 1 to 6, further comprising an adjustment device (160) configured for adjusting the response characteristic of the control device (120).

8. The cooling regulation system (100) according to claim 7 and any of claims 5 to 6, wherein the adjustment device (160) comprises a spring element (161) having a first end (161A) and a second end (161B), wherein the first end (161A) is attached to the rod-like element (122), and wherein the second end (161B) is attached to a regulating screw (162) provided in a wall (118) of the valve (110).

9. A cooling regulation system (100), comprising:
- a valve (110) having an control device (120) provided in the interior of the valve (110), wherein the control device (120) is configured for controlling an opening of an orifice (111) provided between a valve inlet (112) and a valve outlet (113) such that a flow of a coolant from the valve inlet (112) to the valve outlet (113) can be regulated;
- an evaporator (130) with a contact surface that is adapted to be thermally connected to a heat source (140, 141) such that a thermal load from the heat source (140, 141) is dissipated by the evaporator in an operating state of the cooling regulation system (100), the evaporator (130) having an evaporator inlet (131) connected to the valve outlet (113);
- a heater (180) provided at an outlet piping of the evaporator (130), wherein the heater (180) is in thermal contact with the outlet piping via a thermally conducting element (190);
- a regulation device (150) configured for providing a temperature dependent gas pressure to the valve (110) for regulating a position of the control device (120) in order to regulate the flow of the coolant; wherein the regulation device (150) is in thermal contact with the thermally conducting element (190),
the heater (180) is configured to provide a fixed heating power, wherein the fixed heating power is selected such that the heat flux through the thermally conducting element (190) is similar to the maximum potential heat flux through the evaporator (130).

10. Power module, comprising at least one cooling regulation system (100) according any one of claims 1 to 9, wherein at least one of a heat-generating electronic component and a heat-generating electric component is thermally connected to the contact surface of the evaporator (130).

11. A method (200) for automatic cooling regulation, comprising
- providing (210) a coolant in a subcooled state into a valve (110) via a valve inlet (112);
- guiding (220) the coolant through an orifice (111) having a controllable opening into an evaporator (130), wherein the orifice (111) is provided between the valve inlet (112) and a valve outlet (113) connected to the evaporator (130);
- providing (230) a first heat transfer from a heat source (140, 141) to the coolant in the evaporator (130) such that a thermal load from the heat source (140, 141) is dissipated by the evaporator in an operating state of the cooling regulation system (100);
- providing (240) a second heat transfer to a regulation device (150) configured for providing a temperature dependent gas pressure to the valve (110) in order to regulate a coolant flow,
wherein the regulation device (150) is either in thermal contact with the evaporator (130) at a position at which a vapor quality χ of the coolant is χ ≤ χ_{cr}, wherein χ_{cr} is the critical vapor quality, the regulation device (150) being positioned in a heat flow path between the heat source (140, 141) and at least one channel of an array of channels (170) of the evaporator (130) through which the coolant is provided, or
wherein the regulation device (150) is in thermal contact with a thermally conducting element (190) which is in thermal contact with a heater (180) provided at an outlet piping of the evaporator (130), wherein the heater (180) is configured to provide a fixed heating power which is selected such that the heat flux through the thermally conducting element (190) is similar to a maximum potential heat flux through the evaporator (130); and
- regulating (250) the coolant flow by a control device (120) provided in the interior of the valve (110), wherein the control device (120) is configured for a controlling the opening of the orifice (111) provided between the valve inlet (112) and the valve outlet (113).

12. The method according to claim 11, wherein regulating (250) the coolant flow results in regulating the cooling efficiency of the evaporator (130).

13. The method according to claim 11 or 12, further comprising discharging (260) the coolant from the evaporator in a saturated state.

14. The method according to any of claims 11 to 13, wherein regulating (250) the coolant flow by the control device (120) comprises flexing a membrane (121) of the control device (120) such that a rod-like element (10) rigidly connected to the membrane (121) is movable in order to control the opening of the orifice (111) by an adjustment element (123) of the rod-like element (122).

15. The method according to any of claims 11 to 14, further comprising adjusting (270) the response characteristic of the control device (120) by an adjustment device (160).

## Patentansprüche

1. Kühlungsregulierungssystem (100), umfassend:
- ein Ventil (110), das eine im Inneren des Ventils (110) bereitgestellte Steuereinrichtung (120) aufweist, wobei die Steuereinrichtung (120) dafür ausgelegt ist, einen Durchlass einer zwischen einem Ventileinlass (112) und einem Ventilauslass (113) bereitgestellten Öffnung (111) derart zu steuern, dass ein Strom eines Kühlmittels von dem Ventileinlass (112) zu dem Ventilauslass (113) reguliert werden kann;
- einen Verdampfer (130) mit einer Kontaktfläche, die dafür eingerichtet ist, mit einer Wärmequelle (140, 141) derart thermisch verbunden zu sein, dass in einem Betriebszustand des Kühlungsregulierungssystems (100) eine thermische Last von der Wärmequelle (140, 141) durch den Verdampfer abgeleitet wird, wobei der Verdampfer (130) einen mit dem Ventilauslass (113) verbundenen Verdampfereinlass (131) aufweist; und
- eine Reguliereinrichtung (150), die dafür ausgelegt ist, dem Ventil (110) einen temperaturabhängigen Gasdruck zum Regulieren einer Position der Steuereinrichtung (120) bereitzustellen, um den Strom des Kühlmittels zu regulieren;
wobei die Reguliereinrichtung (150) mit dem Verdampfer (130) an einer Position in thermischem Kontakt steht, an der eine Dampfeigenschaft χ des Kühlmittels χ ≤ χ_{cr} beträgt, wobei χ_{cr} die kritische Dampfeigenschaft ist;
wobei die Reguliereinrichtung (150) in einem Wärmestromweg zwischen der Wärmequelle (140, 141) und mindestens einem Kanal einer Anordnung aus Kanälen (170) des Verdampfers (130) positioniert ist, durch die das Kühlmittel bereitgestellt wird.

2. Kühlungsregulierungssystem (100) nach Anspruch 1, wobei die Reguliereinrichtung (150) einen Kolben umfasst, der ein festes Adsorbens (155) enthält, insbesondere Aktivkohle und/oder Kieselgel und/oder Zeolith.

3. Kühlungsregulierungssystem (100) nach einem der Ansprüche 1 bis 2, wobei das Ventil (110) einen ersten Ventilabschnitt (110A), der mit der Reguliereinrichtung (150) verbunden ist, und einen zweiten Ventilabschnitt (110B) umfasst, der über den Ventilausgang (113) mit dem Verdampfer (130) verbunden ist.

4. Kühlungsregulierungssystem (100) nach Anspruch 3, wobei der erste Ventilabschnitt (110A) und die Reguliereinrichtung (150) ein Gas enthalten, das einen temperaturabhängigen Druck aufweist.

5. Kühlungsregulierungssystem (100) nach Anspruch 3 oder 4, wobei die Steuereinrichtung (120) eine Membran (121) umfasst, die den ersten Ventilabschnitt (110A) und den zweiten Ventilabschnitt (110B) trennt, und wobei die Steuereinrichtung (120) ein starr mit der Membran (121) verbundenes Stabelement (122) umfasst.

6. Kühlungsregulierungssystem (100) nach Anspruch 5, wobei das Stabelement (122) ein Einstellelement (123) aufweist, das dafür ausgelegt ist, den Durchlass der Öffnung (111) einzustellen.

7. Kühlungsregulierungssystem (100) nach einem der Ansprüche 1 bis 6, ferner umfassend eine Einstelleinrichtung (160), die dafür ausgelegt ist, die Ansprechcharakteristik der Steuereinrichtung (120) einzustellen.

8. Kühlungsregulierungssystem (100) nach Anspruch 7 und einem der Ansprüche 5 bis 6, wobei die Einstelleinrichtung (160) ein Federelement (161) umfasst, das ein erstes Ende (161A) und ein zweites Ende (161B) aufweist, wobei das erste Ende (161A) an dem Stabelement (122) angebracht ist und wobei das zweite Ende (161B) an einer in einer Wand (118) des Ventils (110) bereitgestellten Stellschraube (162) angebracht ist.

9. Kühlungsregulierungssystem (100), umfassend:
- ein Ventil (110), das eine im Inneren des Ventils (110) bereitgestellte Steuereinrichtung (120) aufweist, wobei die Steuereinrichtung (120) dafür ausgelegt ist, einen Durchlass einer zwischen einem Ventileinlass (112) und einem Ventilauslass (113) bereitgestellten Öffnung (111) derart zu steuern, dass ein Strom eines Kühlmittels von dem Ventileinlass (112) zu dem Ventilauslass (113) reguliert werden kann;
- einen Verdampfer (130) mit einer Kontaktfläche, die dafür eingerichtet ist, mit einer Wärmequelle (140, 141) derart thermisch verbunden zu sein, dass in einem Betriebszustand des Kühlungsregulierungssystems (100) eine thermische Last von der Wärmequelle (140, 141) durch den Verdampfer abgeleitet wird, wobei der Verdampfer (130) einen mit dem Ventilauslass (113) verbundenen Verdampfereinlass (131) aufweist;
- eine an einer Auslassleitung des Verdampfers (130) bereitgestellte Heizvorrichtung (180), wobei die Heizvorrichtung (180) über ein thermisch leitendes Element (190) mit der Auslassleitung in thermischem Kontakt steht;
- eine Reguliereinrichtung (150), die dafür ausgelegt ist, dem Ventil (110) einen temperaturabhängigen Gasdruck zum Regulieren einer Position der Steuereinrichtung (120) bereitzustellen, um den Strom des Kühlmittels zu regulieren, wobei die Reguliereinrichtung (150) mit dem thermisch leitenden Element (190) in thermischem Kontakt steht;
wobei die Heizvorrichtung (180) dafür ausgelegt ist, eine festgelegte Heizleistung bereitzustellen, wobei die festgelegte Heizleistung derart ausgewählt ist, dass der Wärmefluss durch das thermisch leitende Element (190) dem maximal möglichen Wärmefluss durch den Verdampfer (130) ähnelt.

10. Leistungsmodul, das mindestens ein Kühlungsregulierungssystem (100) nach einem der Ansprüche 1 bis 9 umfasst, wobei eine wärmeerzeugende elektronische Komponente und/oder eine wärmeerzeugende elektrische Komponente mit der Kontaktfläche des Verdampfers (130) thermisch verbunden ist.

11. Verfahren (200) zur automatischen Kühlungsregulierung, umfassend:
- Bereitstellen (210) eines Kühlmittels in einem unterkühlten Zustand in ein Ventil (110) über einen Ventileinlass (112);
- Leiten (220) des Kühlmittels durch eine einen steuerbaren Durchlass aufweisende Öffnung (111) in einen Verdampfer (130), wobei die Öffnung (111) zwischen dem Ventileinlass (112) und einem mit dem Verdampfer (130) verbundenen Ventilauslass (113) bereitgestellt ist;
- Bereitstellen (230) einer ersten Wärmeübertragung von einer Wärmequelle (140, 141) an das Kühlmittel in dem Verdampfer (130) derart, dass in einem Betriebszustand des Kühlungsregulierungssystems (100) eine thermische Last von der Wärmequelle (140, 141) durch den Verdampfer abgeleitet wird;
- Bereitstellen (240) einer zweiten Wärmeübertragung an eine Reguliereinrichtung (150), die dafür ausgelegt ist, dem Ventil (110) einen temperaturabhängigen Gasdruck bereitzustellen, um einen Kühlmittelstrom zu regulieren, wobei entweder die Reguliereinrichtung (150) mit dem Verdampfer (130) an einer Position in thermischem Kontakt steht, an der eine Dampfeigenschaft χ des Kühlmittels χ ≤ χ_{cr} beträgt, wobei χ_{cr} die kritische Dampfeigenschaft ist, wobei die Reguliereinrichtung (150) in einem Wärmestromweg zwischen der Wärmequelle (140, 141) und mindestens einem Kanal einer Anordnung aus Kanälen (170) des Verdampfers (130) positioniert ist, durch die das Kühlmittel bereitgestellt wird, oder
wobei die Reguliereinrichtung (150) mit einem thermisch leitenden Element (190) in thermischem Kontakt steht, welches mit einer an einer Auslassleitung des Verdampfers (130) bereitgestellten Heizvorrichtung (180) in thermischem Kontakt steht, wobei die Heizvorrichtung (180) dafür ausgelegt ist, eine festgelegte Heizleistung bereitzustellen, die derart ausgewählt ist, dass der Wärmefluss durch das thermisch leitende Element (190) einem maximal möglichen Wärmefluss durch den Verdampfer (130) ähnelt; und
- Regulieren (250) des Kühlmittelstroms durch eine im Inneren des Ventils (110) bereitgestellte Steuereinrichtung (120), wobei die Steuereinrichtung (120) dafür ausgelegt ist, den Durchlass der zwischen dem Ventileinlass (112) und dem Ventilauslass (113) bereitgestellten Öffnung (111) zu steuern.

12. Verfahren nach Anspruch 11, wobei das Regulieren (250) des Kühlmittelstroms in einem Regulieren der Kühlwirkung des Verdampfers (130) resultiert.

13. Verfahren nach Anspruch 11 oder 12, ferner umfassend ein Abführen (260) des Kühlmittels aus dem Verdampfer in einem gesättigten Zustand.

14. Verfahren nach einem der Ansprüche 11 bis 13, wobei das Regulieren (250) des Kühlmittelstroms durch die Steuereinrichtung (120) ein Biegen einer Membran (121) der Steuereinrichtung (120) derart umfasst, dass ein starr mit der Membran (121) verbundenes Stabelement (10) bewegbar ist, um den Durchlass der Öffnung (111) durch ein Einstellelement (123) des Stabelements (122) zu steuern.

15. Verfahren nach einem der Ansprüche 11 bis 14, ferner umfassend ein Einstellen (270) der Ansprechcharakteristik der Steuereinrichtung (120) durch eine Einstelleinrichtung (160).

## Revendications

1. Système de régulation de refroidissement (100), comprenant:
une soupape (110) équipée d'un dispositif de commande (120) prévu à l'intérieur de la soupape (110), dans lequel le dispositif de commande (120) est configuré de manière à commander une ouverture d'un orifice (111) prévu entre une entrée de soupape (112) et une sortie de soupape (113) de telle sorte qu'un écoulement d'un agent de refroidissement à partir de l'entrée de soupape (112) jusqu'à la sortie de soupape (113) puisse être régulé;
un évaporateur (130) présentant une surface de contact qui est adaptée pour être connectée thermiquement à une source de chaleur (140, 141), de telle sorte qu'une charge thermique en provenance de la source de chaleur (140, 141) soit dissipée par l'évaporateur dans un état de fonctionnement du système de régulation de refroidissement (100), l'évaporateur (130) présentant une entrée d'évaporateur (131) connectée à la sortie de soupape (113); et
un dispositif de régulation (150) configuré de manière à fournir une pression de gaz dépendant de la température à la soupape (110) afin de réguler une position du dispositif de commande (120) dans le but de réguler l'écoulement de l'agent de refroidissement;
dans lequel le dispositif de régulation (150) se trouve en contact thermique avec l'évaporateur (130) à une position dans laquelle une qualité de vapeur χ de l'agent de refroidissement est χ ≤ χ_{cr}, où χ_{cr} est la qualité de vapeur critique,
le dispositif de régulation (150) est positionné dans un chemin d'écoulement de chaleur entre la source de chaleur (140, 141) et au moins un canal d'un réseau de canaux (170) de l'évaporateur (130) à travers lesquels l'agent de refroidissement est fourni.

2. Système de régulation de refroidissement (100) selon la revendication 1, dans lequel le dispositif de régulation (150) comprend une ampoule contenant un adsorbant solide (155), en particulier du charbon actif et/ou du gel de silice et/ou de la zéolite.

3. Système de régulation de refroidissement (100) selon l'une quelconque des revendications 1 à 2, dans lequel la soupape (110) comprend une première partie de soupape (110A) qui est connectée au dispositif de régulation (150) et une seconde partie de soupape (110B) qui est connectée à l'évaporateur (130) par l'intermédiaire de la sortie de soupape (113).

4. Système de régulation de refroidissement (100) selon la revendication 3, dans lequel la première partie de soupape (110A) et le dispositif de régulation (150) contiennent un gaz qui affiche une pression dépendant de la température.

5. Système de régulation de refroidissement (100) selon la revendication 3 ou 4, dans lequel le dispositif de commande (120) comprend une membrane (121) qui sépare la première partie de soupape (110A) et la seconde partie de soupape (110B), et dans lequel le dispositif de commande (120) comprend un élément en forme de tige (122) qui est connecté de façon rigide à la membrane (121).

6. Système de régulation de refroidissement (100) selon la revendication à 5, dans lequel l'élément en forme de tige (122) présente un élément de réglage (123) configuré de manière à régler l'ouverture de l'orifice (111) .

7. Système de régulation de refroidissement (100) selon l'une quelconque des revendications 1 à 6, comprenant en outre un dispositif de réglage (160) configuré de manière à régler la caractéristique de réponse du dispositif de commande (120).

8. Système de régulation de refroidissement (100) selon la revendication 7 et l'une quelconque des revendications 5 à 6, dans lequel le dispositif de réglage (160) comprend un élément de ressort (161) qui présente une première extrémité (161A) et une seconde extrémité (161B), dans lequel la première extrémité (161A) est attachée à l'élément en forme de tige (122), et dans lequel la seconde extrémité (161B) est attachée à une vis de régulation (162) prévue dans une paroi (118) de la soupape (110).

9. Système de régulation de refroidissement (100), comprenant:
une soupape (110) équipée d'un dispositif de commande (120) prévu à l'intérieur de la soupape (110), dans lequel le dispositif de commande (120) est configuré de manière à commander une ouverture d'un orifice (111) prévu entre une entrée de soupape (112) et une sortie de soupape (113) de telle sorte qu'un écoulement d'un agent de refroidissement à partir de l'entrée de soupape (112) jusqu'à la sortie de soupape (113) puisse être régulé;
un évaporateur (130) présentant une surface de contact qui est adaptée pour être connectée thermiquement à une source de chaleur (140, 141) de telle sorte qu'une charge thermique en provenance de la source de chaleur (140, 141) soit dissipée par l'évaporateur dans un état de fonctionnement du système de régulation de refroidissement (100), l'évaporateur (130) présentant une entrée d'évaporateur (131) connectée à la sortie de soupape (113);
un dispositif de chauffage (180) prévu au niveau d'une conduite de sortie de l'évaporateur (130), dans lequel le dispositif de chauffage (180) se trouve en contact thermique avec la conduite de sortie par l'intermédiaire d'une élément thermiquement conducteur (190) ;
un dispositif de régulation (150) configuré de manière à fournir une pression de gaz dépendant de la température à la soupape (110) afin de réguler une position du dispositif de commande (120) dans le but de réguler l'écoulement de l'agent de refroidissement;
dans lequel le dispositif de régulation (150) se trouve en contact thermique avec l'élément thermiquement conducteur (190), et
le dispositif de chauffage (180) est configuré de manière à fournir une puissance de chauffage constante, dans lequel la puissance de chauffage constante est sélectionnée de telle sorte que le flux de chaleur à travers l'élément thermiquement conducteur (190) soit similaire au flux de chaleur potentiel maximum à travers l'évaporateur (130).

10. Module de puissance, comprenant au moins un système de régulation de refroidissement (100) selon l'une quelconque des revendications 1 à 9, dans lequel au moins un composant parmi un composant électronique de génération de chaleur et un composant électrique de génération de chaleur est connecté thermiquement à la surface de contact de l'évaporateur (130).

11. Procédé (200) de régulation de refroidissement automatique, comprenant les étapes suivantes:
introduire (210) un agent de refroidissement dans un état sous-refroidi dans une soupape (110) par l'intermédiaire d'une entrée de soupape (112);
guider (220) l'agent de refroidissement à travers un orifice (111) présentant une ouverture commandable dans un évaporateur (130), dans lequel l'orifice (111) est prévu entre l'entrée de soupape (112) et une sortie de soupape (113) connectée à l'évaporateur (130);
appliquer (230) un premier transfert de chaleur à partir d'une source de chaleur (140, 141) à l'agent de refroidissement dans l'évaporateur (130) de telle sorte qu'une charge thermique en provenance de la source de chaleur (140, 141) soit dissipée par l'évaporateur dans un état de fonctionnement du système de régulation de refroidissement (100); et
effectuer (240) un second transfert de chaleur au niveau d'un dispositif de régulation (150) configuré de manière à fournir une pression de gaz dépendant de la température à la soupape (110) dans le but de réguler un écoulement d'agent de refroidissement,
dans lequel soit le dispositif de régulation (150) se trouve en contact thermique avec l'évaporateur (130) à une position dans laquelle une qualité de vapeur χ de l'agent de refroidissement est χ ≤ χ_{cr}, où χ_{cr} est la qualité de vapeur critique, le dispositif de régulation (150) étant positionné dans un chemin d'écoulement de chaleur entre la source de chaleur (140, 141) et au moins un canal d'un réseau de canaux (170) de l'évaporateur (130) à travers lesquels l'agent de refroidissement est prévu, soit
dans lequel le dispositif de régulation (150) se trouve en contact thermique avec un élément thermiquement conducteur (190) qui se trouve en contact thermique avec un dispositif de chauffage (180) prévu au niveau d'une conduite de sortie de l'évaporateur (130), dans lequel le dispositif de chauffage (180) est configuré de manière à fournir une puissance de chauffage constante qui est sélectionnée de telle sorte que le flux de chaleur à travers l'élément thermiquement conducteur (190) soit similaire à un flux de chaleur potentiel maximum à travers l'évaporateur (130); et
réguler (250) l'écoulement d'agent de refroidissement à l'aide d'un dispositif de commande (120) prévu à l'intérieur de la soupape (110), dans lequel le dispositif de commande (120) est configuré de manière à commander l'ouverture de l'orifice (111) prévu entre l'entrée de soupape (112) et la sortie de soupape (113) .

12. Procédé selon la revendication 11, dans lequel la régulation (250) de l'écoulement d'agent de refroidissement résulte en la régulation de l'efficacité de refroidissement de l'évaporateur (130).

13. Procédé selon la revendication 11 ou 12, comprenant en outre la décharge (260) de l'agent de refroidissement à partir de l'évaporateur dans un état saturé.

14. Procédé selon l'une quelconque des revendications 11 à 13, dans lequel la régulation (250) de l'écoulement d'agent de refroidissement par le dispositif de commande (120) comprend la flexion d'une membrane (121) du dispositif de commande (120) de telle sorte qu'un élément en forme de tige (10) qui est connecté de façon rigide à la membrane (121) soit déplaçable dans le but de commander l'ouverture de l'orifice (111) par un élément de réglage (123) de l'élément en forme de tige (122) .

15. Procédé selon l'une quelconque des revendications 11 à 14, comprenant en outre le réglage (270) de la caractéristique de réponse du dispositif de commande (120) à l'aide d'un dispositif de réglage (160).
